# FASCICULE DE BREVET EUROPEEN

(11) **EP 1 716 425 B1**
(45) Date de publication et mention de la délivrance du brevet: **19.08.2009**
(21) Numéro de dépôt: 05717613.3
(22) Date de dépôt: 11.02.2005
(51) Int. Cl.: G01R 31/3185

(54) **PROCEDE D ELABORATION DE FICHIERS DE DESCRIPTION HDL DE SYSTEMES DIGITAUX ET SYSTEMES OBTENUS**
VERFAHREN ZUM ERZEUGEN VON HDL-BESCHREIBUNGSDATEIEN DIGITALER SYSTEME UND ERHALTENE SYSTEME
METHOD FOR CREATING HDL DESCRIPTION FILES OF DIGITAL SYSTEMS, AND SYSTEMS OBTAINED

(30) Priorité: 13.02.2004 FR 0401479; 30.08.2004 FR 0409181
(43) Date de publication de la demande: 02.11.2006
(73) Titulaire: INSTITUT NATIONAL POLYTECHNIQUE DE GRENOBLE, F-38031 Grenoble (FR)
(72) Inventeur: AKTOUF, Chouki, F-26000 Valence (FR)
(74) Mandataire: Blanchard, Eugène Gilles
(86) Numéro de dépôt international: PCT/FR2005/000323
(87) Numéro de publication internationale: WO 2005/083454

(56) Documents cités:
- US-A1- 2003 023 941
- US-B1- 6 256 770
- AKTOUF C ET AL: "Inserting scan at the behavioral level" IEEE DESIGN & TEST OF COMPUTERS IEEE USA, vol. 17, no. 3, juillet 2000 (2000-07), pages 34-42, XP002321051 ISSN: 0740-7475
- HUANG Y ET AL: "On RTL scan design" PROCEEDINGS INTERNATIONAL TEST CONFERENCE 2001. ITC 2001. BALTIMORE, MD, OCT. 30 - NOV. 1, 2001, INTERNATIONAL TEST CONFERENCE, NEW YORK, NY : IEEE, US, 30 octobre 2001 (2001-10-30), pages 728-737, XP002958209 ISBN: 0-7803-7169-0

## Description

La présente invention concerne, d'une part, le domaine technique de la conception, assistée par ordinateur (CAO), de systèmes électroniques digitaux intégrés, encore appelés « puces électroniques » et, d'autre part, le domaine technique des puces électroniques obtenues.

De manière générale, la conception de systèmes électroniques complexes, destinés à être intégrés sur une même puce électronique, fait intervenir une phase d'élaboration d'une description du système électronique intégré dans un langage, dit de haut niveau (HDL - High level Description Language), à un niveau, dit de transfert des registres (RTL - Register Transfert Level). Les langages les plus communément utilisés, pour réaliser une telle description HDL, sont les langages Verilog ou VHDL, sans qu'il faille considérer que ces langages soient les seuls permettant une description HDL au niveau RTL d'un système digital électronique intégré.

La description d'un système électronique intégré en langages HDL se matérialise le plus souvent sous la forme d'un système de fichiers électroniques ou base de données de description pouvant alors être constitué par un seul et même fichier texte établi en langage HDL ou, au contraire, comprendre plusieurs fichiers textes de description, certains des fichiers correspondant à la description particulière de modules ou de parties du système intégré, tandis que d'autres fichiers décrivent l'interaction et les relations entre les différents modules et les liens existant entre ces derniers.

Pour obtenir une description de la puce électronique qui pourraient être qualifiée de matérielle par rapport à la description en langage HDL qui pourrait être qualifiée de fonctionnelle ou comportementale, il est réalisé, à partir du système de fichiers de description HDL, une synthèse ou compilation au moyen d'un outil informatique, généralement baptisé compilateur de silicium, permettant d'obtenir une description matérielle au niveau des portes logiques, en fonction de la technologie retenue, description encore appelée « netlist » qui sera ensuite utilisée pour obtenir une représentation physique du système électronique intégré sous la forme de masques permettant la fabrication de la puce, conformément aux différentes techniques connues, ces dernières n'entrant pas dans le cadre de la présente invention.

Un système électronique digital intégré ainsi obtenu doit, bien entendu, offrir une garantie de fiabilité et de fonctionnement conforme à l'objectif visé lors de sa conception.

Ainsi, il apparaît nécessaire, lors de la conception d'un système électronique, de prévoir des systèmes ou des moyens permettant d'en vérifier le parfait fonctionnement, de manière bien entendue automatisée, soit au moyen de dispositifs extérieurs qui seront connectés au système électronique intégré, une fois ce dernier fabriqué, soit au moyen, de systèmes de tests faisant partie intégrante du système électronique intégré obtenu.

De manière générale, une telle démarche, orientée vers la testabilité des systèmes électroniques intégrés, est qualifiée de technique de DFT, pour « Design For Test » : conception pour le test, et, de manière plus particulière, lorsqu'il est prévu d'incorporer au système électronique intégré ses propres moyens de test automatique, on parle de BIST, pour « Built In Self Test » : auto test intégré.

Une première démarche, en vue de vérifier le bon fonctionnement d'un système électronique digital intégré, consiste, tout d'abord, à vérifier le parfait fonctionnement des éléments mémoire, bascules ou « flip-flop » présents au sein du système intégré et destinés à stocker, temporairement, des résultats intermédiaires de traitement ou des valeurs de signaux. Il s'agit ici d'éléments mémoire locaux présents au sein des composants dits séquentiels. Ces derniers représentent la majorité des circuits intégrés complexes tels que les microprocesseurs ou les processeurs de traitement de signal. Un circuit séquentiel étant composé d'éléments de logique combinatoire et d'éléments séquentiels ou bascules à distinguer des éléments mémoires des modules de mémoire vive RAM ou morte ROM.

Le test des circuits séquentiels passe par une étape de génération de vecteurs de tests en utilisant des outils logiciels spécialisés dits ATPG pour « Automatic Test Pattern Generators ». La qualité des vecteurs de test générés détermine la phase de test après fabrication et la capacité des vecteurs de test à révéler la présence des défauts. La génération de vecteurs de test de qualité nécessite la prise en compte des techniques de DFT telle que le SCAN. La technique de « SCAN » consiste à chaîner entre eux les différents éléments mémoire, de manière à obtenir une ou plusieurs chaînes de SCAN qui seront activées dans le cadre d'un fonctionnement en mode test du circuit intégré.

La mise en place des fonctionnalités de SCAN et du chaînage des éléments mémoire peut intervenir au niveau de la description matérielle (netlist) du circuit électronique digital intégré comme décrit dans le brevet US 6,311,317. Toutefois, compte tenu du nombre très important de portes logiques notamment, cette insertion effectuée de manière automatique ou semi-automatique requiert un temps très important de calcul. De plus, cette insertion est susceptible de perturber le fonctionnement en mode normal du système logique électronique intégré, de sorte que, après avoir procédé à ce chaînage des éléments au niveau de la description matérielle netlist, il peut apparaître nécessaire de modifier la conception du circuit et donc de réécrire la description en langage HDL de ce dernier, pour ensuite procéder à une nouvelle compilation silicium et une nouvelle insertion du chaînage des éléments mémoire au niveau netlist.

Or, ce processus itératif, qui peut s'avérer très long et consommateur de ressources matérielles et humaines, constitue un obstacle à la réduction du temps nécessaire pour la conception de systèmes électroniques intégrés fiables et performants.

Ainsi, il est apparu que, si l'intégration des fonctionnalités de SCAN pouvaient être effectuées au niveau de la description HDL avant la phase de synthèse, il serait possible d'obtenir une réduction substantielle du temps de conception du circuit électronique intégré.

Ainsi, une autre voie a été proposée consistant à incorporer les fonctionnalités, dites de chaînage ou de SCAN, au niveau RTL, dans le cadre de la description HDL du système électronique digital intégré.

Le brevet US 6,256,770 a, par exemple, proposé un procédé et un dispositif de mise en oeuvre de fonctionnalité de test d'un système électronique intégré dans le cadre de sa description en langage HDL. Selon ce brevet il est prévu, tout d'abord, d'attribuer des portions de chaînes d'éléments mémoire à différents modules du circuit, puis de procéder à un ordonnancement de ces portions de chaînes d'éléments mémoire sur la base d'une analyse des relations fonctionnelles existant entre les éléments mémoire ou les vecteurs de données dans les descriptions HDL des modules. Il est alors procédé, sur la base de cet ordonnancement, à une insertion des instructions de chaînage dans la description en langage HDL du module concerné, de manière que, lors de la synthèse dudit module, le système électronique digital intégré incorpore, pour chaque module concerné, les circuits électroniques logiques nécessaires au test qui découle d'un tel chaînage.

Un tel procédé et dispositif permet, effectivement, une insertion automatique d'instructions HDL permettant d'obtenir, lors de la synthèse du circuit, les fonctionnalités de SCAN, permettant d'assurer la génération de vecteurs de test de bonne qualité pour le circuit intégré sous test 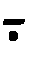

Toutefois, il est apparu à l'usage que l'étape d'analyse des relations fonctionnelles, existant entre les différents vecteurs de données, dans le cade de la conception de systèmes électroniques digitaux intégrés particulièrement complexes, induit un temps de calcul particulièrement important, de sorte que les bénéfices de l'insertion au niveau RTL en langage HDL des fonctionnalités de SCAN se trouvent amoindris, voire annulés par les temps de calcul ou la puissance de calcul requise pour procéder à cette insertion, conformément au brevet US 6,256,770.

Une demande de brevet US 2003/0023941 présente une autre manière de procéder à l'insertion automatique au niveau RTL d'instructions en langage HDL, permettant de mettre en oeuvre les fonctionnalités de SCAN dans le système électronique intégré qui sera obtenu par la synthèse de la description HDL ainsi modifiée. Selon ce document, l'insertion des chaînes de SCAN et des points de test au niveau RTL en langage HDL est effectuée en réalisant, tout d'abord, une analyse de la testabilité de la descriptions en langage HDL du système électronique intégré.

Or, si la méthode proposée par la demande US 2003/0023941 permet, effectivement, une insertion automatique des instructions HDL correspondant à des fonctionnalités de SCAN après synthèse, l'analyse de testabilité se trouve être une étape particulièrement consommatrice de ressources de calcul ou de temps, de sorte que les gains, obtenus par la modification automatique au niveau HDL du système électronique intégré, se trouvent dans ce cas également minimisés par les temps de calcul d'analyse de testabilité.

Par ailleurs, la demande US 2003/0023941 propose également de procéder à l'insertion des chaînes SCAN en effectuant une identification et une analyse des différents domaines d'horloge existants puis un calcul de minimisation des coûts de génération de test et de minimisation des domaines d'horloges. Or, cette analyse des domaines d'horloge et cette minimisation requiert également des ressources importantes. Les inventeurs ont proposé, dans l'article « Inserting scan at the behavioral level » IEEE Design (Test of Computers IEEE USA, vol. 17, n°3, juillet 2000 pages 34-42) un procédé conforme au préambule de la revendication 1 et qui prévoit la localisation dans les fichiers de description HDL originaux des séquences qui seront à l'origine d'éléments mémoires ainsi que l'insertion dans une partie des fichiers de description HDL d'instructions HDL dites de SCAN pour obtenir lors de la synthèse du système, au moins une chaîne, dite de « SCAN ».

Il apparaît donc le besoin d'une méthode qui, en assurant une insertion automatique dans le cadre de la description HDL au niveau RTL d'un système électronique digital intégré, des fonctionnalités de SCAN, permette de réduire substantiellement les temps de calcul, tout en offrant un système électronique digital intégré qui, après synthèse, présentera des performances au moins équivalentes à celles des systèmes intégrés qui seraient synthétisés à partir des descriptions HDL au niveau RTL traitées par les méthodes selon l'art antérieur.

Afin d'atteindre cet objectif, l'invention concerne un procédé conforme à la revendication 1. Ce procédé diffère du procédé précédemment décrit dans l'article sus-évoqué en ce qu'il comprend une étape d'analyse ou d'indexation de l'ensemble de fichiers originaux de description HDL et de création d'au moins un fichier d'indexation et en ce qu'il comprend également une phase de localisation des mémoires.

Au sens de l'invention, l'ensemble de fichiers de description HDL d'un système électronique digital intégré comprend un ou plusieurs fichiers de texte ou code ASCII qui décrivent en instruction HDL un, plusieurs ou tous les modules fonctionnels du système électronique digital intégré ainsi que les relations éventuelles existant entre les différents modules. Selon l'invention la description HDL du système électronique digital intégré peut également être réalisée dans le cadre d'une base de données de description.

De même au sens de l'invention, il est effectué l'insertion de l'ensemble des instructions HDL nécessaire à la mise en oeuvre du test dit de SCAN à savoir notamment l'insertion des instructions permettant la mise du circuit à tester en mode de test, les instructions d'entrée de signal de test, de sortie de signal de test, les instructions de mise en oeuvre d'une horloge de test, les instructions assurant le chaînage des éléments mémoire ainsi que les instructions de définition d'un contrôleur de test de SCAN sans que cette liste puisse être considérée comme possédant un caractère exhaustif ou exclusif d'autres fonctionnalités qui pourraient être nécessaire à la mise en oeuvre du test de SCAN.

Le procédé selon l'invention présente l'avantage, du fait de l'insertion séquentielle des instructions de chaînage des éléments au fur et à mesure de leur apparition dans les pages de description HDL (i.e. sans analyse de leur éventuelles relations), de ne pas nécessiter d'importantes ressources de calcul de sorte que le procédé selon l'invention peut être mis en oeuvre sur un ordinateur, tel qu'un ordinateur personnel, tout en obtenant des temps de traitement moindres que ceux nécessaires pour la mise en oeuvre des procédés selon l'art antérieur.

En effet, les inventeurs ont eu le mérite de mettre en évidence qu'il n'était pas nécessaire de procéder à une analyse, relationnelle ou fonctionnelle, ni même à une analyse de testabilité pour procéder à l'insertion des instructions HDL nécessaires à la mise en oeuvre des fonctionnalités de SCAN et qu'une insertion séquentielle desdites instructions HDL, insertion qui pourrait être qualifiée d'insertion heuristique, au fur et à mesure de l'apparition dans les fichiers de descriptions HDL de ces instructions susceptibles d'engendrer des éléments de mémoire, permettait, en fin de compte, d'obtenir toutes les fonctionnalités de test des éléments mémoire du système électronique digital intégré sans en altérer les performances ni en augmenter de manière trop importante la surface.

L'invention concerne également un système électronique digital intégré résultant de la synthèse d'un ensemble de fichier de description en langage HDL obtenu par la mise en oeuvre du procédé selon l'invention et comprenant une partie au moins des circuits électroniques logiques nécessaires au test du fonctionnement des éléments mémoire au moins, tels qu'une ou plusieurs chaînes de SCAN.

Selon une caractéristique de l'invention, le procédé d'analyse et d'insertion automatique comprend une étape enregistrement du nouvel ensemble de fichiers de description HDL obtenus.

Selon une autre caractéristique de l'invention, afin d'éviter des violations des règles de SCAN lors de la synthèse du circuit à partir du nouvel ensemble de fichiers de description HDL, le procédé d'analyse et d'insertion automatique comprend une étape d'identification des éventuels différents domaines d'horloge existants et l'étape d'insertion d'instructions HDL de chaînage d'éléments mémoire est alors réalisée de manière à créer au moins une chaîne de SCAN distincte pour chaque domaine d'horloge.

Par ailleurs, afin d'assurer une implémentation du SCAN au niveau RTL qui garantisse lors de la synthèse le respect des règles de SCAN, selon l'invention la dimension des variables ou signaux est déterminée avant l'étape d'insertion des instructions HDL de SCAN. Ainsi par exemple dans le cas de variables VHDL de type entier ou énumération, l'invention prévoit que la longueur des mots correspondant ou nombre de bits doit être fixé avant l'insertion des instructions VHDL de SCAN afin de garantir que les mémoires élémentaires constitutives de chaque mémoire sont bien chaînés entre-eux.

De plus, dans la mesure où des informations sur la dimension de certaines variables seraient absentes de l'ensemble de fichiers originaux de description HDL, l'invention prévoit dans une forme préférée de mise en oeuvre, une étape soit de définition automatique de cette dimension sur la base d'une valeur par défaut prédéterminée, soit de définition interactive avec un utilisateur du procédé.

Dans le même sens, et selon une variante de mise de oeuvre préférée, le procédé conforme à l'invention vérifie, lors de l'insertion des instructions HDL de chaînage, la compatibilité des éléments mémoires entre eux. En effet, il n'est possible de chaîner que des éléments mémoires correspondant à des objets de même type et de dimension compatible. Ainsi, en cas d'incompatibilité, l'invention prévoit de manière préférée mais non strictement nécessaire que l'étape d'insertion des instructions HDL de chaînage comprend soit une phase de transformation automatique du type et/ou de la dimension d'un ou des deux objets à l'origine du conflit, soit une phase de modification interactive avec l'utilisateur du type et/ou de la dimension d'un ou des deux objets à l'origine du conflit. En ce qui concerne la détection automatique et la correction de tels conflits correspondant à des erreurs de syntaxe ou grammaticales dans la mise en oeuvre du langage, il est possible de se reporter à la demande de brevet US 2003/0033595.

Selon une autre caractéristique de l'invention, l'étape d'insertion d'instruction HDL de chaînage d'éléments mémoire comprend :
■ une phase d'insertion d'instructions HDL de chaînage dit local d'éléments mémoires au niveau d'ensemble d'instructions HDL correspondant à un processus HDL de manière à obtenir lors de la synthèse au moins une chaîne distincte d'éléments mémoires pour chaque processus HDL,
■ une phase d'insertion d'instruction HDL de chaînage, dit global, au niveau des fichiers de description HDL, de manière à obtenir, lors de la synthèse, au moins une chaîne d'éléments mémoire comprenant les chaînes d'éléments mémoire crées lors de la phase de chaînage local.

De manière général dans le cas du chaînage au sein même des processus on parle de chaînage dans le domaine séquentiel tandis que pour le chaînage hors processus on parle de chaînage dans le domaine concurrent.

Ainsi, selon encore une caractéristique de l'invention, l'étape d'insertion automatique des instructions HDL comprend les phases suivantes :
■ insertion d'instructions HDL correspondant à des signaux de test utilisés comme port d'entrée-sortie,
■ insertion d'instructions HDL correspondant à des signaux intermédiaires de travail, dans le cas d'éléments de mémoire entre plusieurs processus impliquant des ports primaires d'entrée/sortie,
■ insertion, au niveau de chaque processus, d'instructions HDL assurant l'obtention, lors de la synthèse du circuit, d'au moins une chaîne, dite de « SCAN», reliant les éléments mémoires propres au processus,
■ insertion d'instructions HDL assurant une affectation concurrente des chaîne des entrées et sorties des chaîne de SCAN en dehors des processus.

Selon l'invention, le procédé d'analyse et d'insertion d'instructions HDL peut être mis en oeuvre dans le cadre de différents langages de description HDL, tels que Verilog ou VHDL, étant entendu qu'il ne s'agit là que d'exemples non limitatifs et que le procédé selon l'invention pourrait être mis en oeuvre pour encore d'autres langages de description HDL.

De plus, le procédé peut également être mis en oeuvre sur un ensemble hétérogène de fichiers originaux de description en langage HDL comprenant par exemple mais non exclusivement des fichiers de description établis en langage Verilog et d'autres établis en langage VHDL.

Ainsi, selon une autre caractéristique de l'invention, dans le cas de l'utilisation des langages Verilog et VHDL en tant que langages de description HDL, l'étape de localisation des instructions HDL à l'origine des éléments mémoire comprend :
■ une étape de recherche de processus synchronisés afin de détecter les objets affectés à l'intérieur de ces processus,
■ application des règles suivantes pour l'identification des instructions à l'origine des éléments mémoires :
   - tout objet affecté à l'intérieur d'un processus et qui est lu dans un autre processus ou dans la partie concurrente du code HDL sera considéré comme un élément mémoire,
   - dans un processus synchronisé, tout objet affecté dans une branche d'une structure de contrôle « if » sans qu'il soit affecté dans toutes autres branches de cette même structure est considéré comme un élément mémoire,
   - dans un processus synchronisé, tout objet qui est lu avant d'être écrit est considéré comme un élément mémoire.

Dans une forme de mise en oeuvre préférée du procédé selon l'invention et dans le cadre du chaînage local d'un processus décrit en langage VHDL, il est prévu une phase d'insertion d'instructions VHDL de définition de signaux intermédiaires destinés à reprendre les valeurs des chaînes de variables afin de permettre leur affectation et leur chaînage en dehors des processus.

Par ailleurs, selon l'invention, l'insertion automatique des instructions HDL doit être réalisée de manière à n'induire aucune dégradation fonctionnelle du code en langage HDL du système électronique digital intégré original.

Selon une autre caractéristique de l'invention, afin de permettre une optimisation des chaînes de SCAN et une amélioration de la couverture de fautes après synthèse du système électronique digital intégré à partir du nouvel ensemble de fichiers de description HDL, sans qu'il soit nécessaire de modifier à nouveau la description en langage HDL et de mettre à nouveau en oeuvre le procédé selon invention et éviter ainsi un allongement du temps de conception du circuit, il est créé des chaînes de SCAN programmable. A cet effet, l'étape d'insertion des instructions HDL de SCAN comprend une phase d'insertion d"instructions HDL qui lors de la synthèse généreront un multiplexeur programmable intercalé entre certains au moins des éléments mémoire d'une chaîne de SCAN. De manière préférée, il est intercalé un tel multiplexeur entre tous les éléments mémoires successifs des chaînes de SCAN. Bien entendu, il est également procédé à l'insertion des instructions HDL correspondant à un contrôleur des multiplexeurs intercalés dans les chaînes de SCAN.

Il est à noter que les différentes caractéristiques du procédé selon l'invention telles que décrites précisément peuvent être combinées entre elles selon différentes combinaisons lorsque ces caractéristiques ne sont pas incompatibles entre elles.

L'invention concerne également un système électronique digital intégré conforme à la revendication 15.

Selon une autre caractéristique de l'invention, toujours en vue d'améliorer les capacités de test du circuit qui sera obtenu à partir du nouvel ensemble de fichier de description HDL, le procédé comprend une étape d'insertion d'instructions HDL dont la synthèse sera à l'origine de moyens intégrés d'auto test (BIST) du système électronique digital intégré. De tel moyens comprennent au moins un générateur automatique de vecteurs de test (TPG - Test Pattern Generator), des moyens d'analyse de la réponse du système électronique et des moyens de contrôle du test. Selon une caractéristique préférée de mise en oeuvre de l'invention, le générateur automatique de vecteurs de test comprend un registre à décalage à contre réaction linéaire plus connu sous le nom de PRPG (Parallel Random Pattern Generator) et se trouve conçu de manière que la séquence d'initialisation du registre à décalage à contre réaction linéaire soit programmable. Par ailleurs, selon une caractéristique préférée de mise en oeuvre de l'invention, la structure de génération de vecteurs de test et celle de l'analyse des réponses se basent sur la structure de SCAN programmable ou reconfigurable citée ci-dessus.

Les différentes caractéristiques d'un système digital intégré selon l'invention telle qu'évoquée précédemment peuvent être combinées entre elles selon différentes combinaisons lorsque ces caractéristiques ne sont pas incompatibles entre elles.

L'invention concerne, également, un dispositif de conception automatisé en langage de description au niveau transfert de registres, dit langage HDL d'un système complet ou d'une partie de système électronique digital intégré, dispositif comprenant au moins une unité de calcul, une unité de mémoire et une unité de stockage de fichiers, **caractérisé en ce que** l'unité de stockage comprend des fichiers de description en langage HDL du système ou de la partie de système électronique intégré et en ce que les unités de calcul et de mémoire sont adaptées pour générer, en mettant en oeuvre le procédé selon l'invention et à partir des fichiers de description HDL, de nouveaux fichiers de description HDL du système ou de la partie de système qui incorporent des instructions HDL, de manière que le système ou la partie de système électronique digital intégré obtenu à partir des nouveaux fichiers incorpore une partie au moins des circuits électroniques logiques nécessaires au test du fonctionnement des éléments mémoire au moins.

Dans une forme préférée de réalisation le dispositif comprend un ordinateur personnel mettant en oeuvre un programme dont l'exécution permet la mise en oeuvre du procédé selon l'invention.

L'invention concerne aussi un support de données lisibles par ordinateur sur lequel est enregistré un programme dont l'exécution par un ordinateur permet la mise en oeuvre du procédé selon l'invention.

Diverses autres caractéristiques de l'invention ressortent de la description ci-après effectuée en référence aux dessins annexés qui illustrent les différents objets de l'invention dans des formes non limitatives prévues à titre d'exemple.

La **fig. 1** illustre un exemple d'organigramme de mise en oeuvre du procédé selon l'invention.

La **fig. 2** illustre un fichier original de description en langage VHDL d' une portions d'un système digital intégré.

La **fig. 3** illustre un exemple de fichier généré au cours de la mise en oeuvre du procédé selon l'invention sur le fichier de la **fig. 2**.

La **fig. 4** illustre un fichier original de description en langage Verilog d' une portions d'un système digital intégré.

La **fig. 5** illustre un exemple de fichier généré au cours de la mise en oeuvre du procédé selon l'invention sur le fichier de la **fig. 4****.**

Les **fig. 6** et **7** illustrent des exemples de fichier d'indexation des éléments mémoire générés par le procédé selon l'invention pour les fichiers selon les **fig. 2** et **4**.

Les **fig. 8** et **9** montrent les fichiers de description HDL correspondant aux fichiers originaux des **fig. 2** et **4** respectivement, et incorporant les instructions HDL de SCAN insérées de manière automatique par le procédé selon l'invention.

La **fig. 10** illustre schématiquement la mise en oeuvre de moyens reconfiguration des chaînes de SCAN d'un système digital intégré.

La **fig. 11** montre de manière schématique un système digital intégré tel qu'obtenu après synthèse d'une description HDL générée par le procédé selon l'invention et mettant en oeuvre des fonctionnalité d'autotest intégré « BIST ».

Comme cela a été dit précédemment le procédé selon l'invention vise, dans une première forme de mise en oeuvre, à assurer l'insertion au niveau de la description en langage HDL d'un circuit d'instructions HDL qui après synthèse du circuit conféreront au circuit l'ensemble des moyens nécessaires au test d'une partie au moins de ses éléments mémoires selon la technique de SCAN. L'invention vise à atteindre cet objectif en n'effectuant aucune analyse prospective du circuit telle qu'une analyse relationnelle ou fonctionnelle nécessitant d'importantes ressources de calcul et engendrant des temps de traitement également importants. Au contraire selon l'invention, l'insertion des instructions correspondant aux chaînes de SCAN et aux fonctionnalités associées est effectuée au fur et à mesure de l'occurrence des éléments mémoires ou des instructions HDL correspondant aux éléments mémoires. Selon l'invention ce chaînage est bien entendu réalisé en contrôlant au fur et à mesure de l'avancement que la ou les chaînes de SCAN en cours de réalisation sont conformes aux critères éventuellement imposés par l'utilisateur et les corrections éventuellement nécessaires sont effectuées en intervenant sur les chaînes et/ou les tronçons de chaîne déjà réalisés.

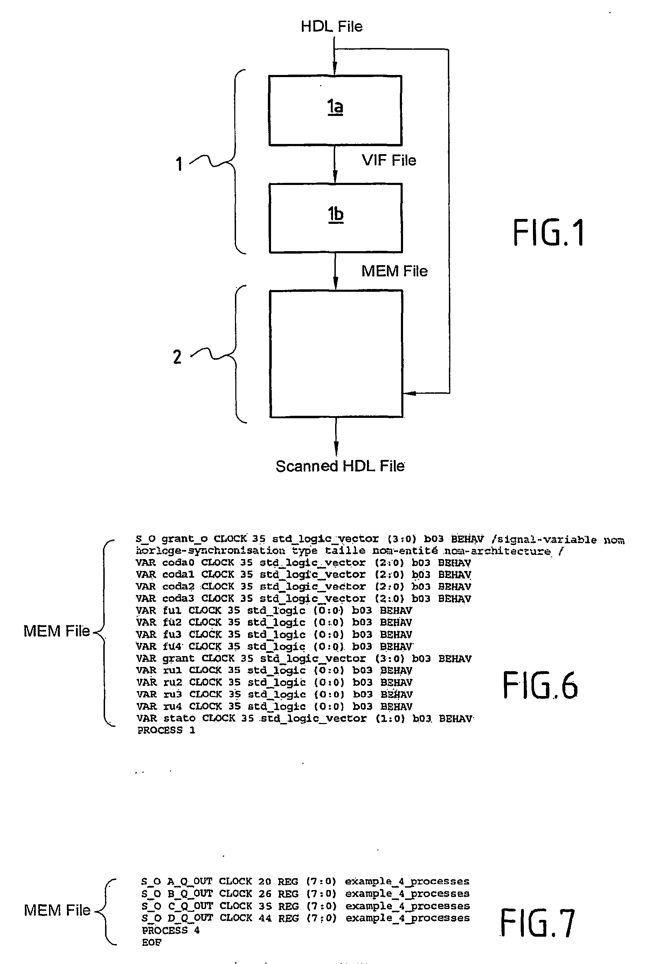

Dans une forme de mise en oeuvre préférée, le procédé selon l'invention, dont un organigramme est illustré à la fig.1, comprend tout d'abord une étape **1** de localisation automatique des instructions qui seront lors de la synthèse du système à l'origine d éléments mémoire.

Cette localisation automatique peut faire intervenir plusieurs phases et dans une forme de mise en oeuvre préférée l'étape de localisation automatique comprend une étape **1a** d'analyse ou d'indexation de l'ensemble des fichiers originaux de description en vue de la création d'au moins un fichier d'indexation **VIF File** comprenant la liste des unités de conception si elles existent (entité, librairie, paquetage), et pour chaque unité de conception l'ensemble des déclarations, chaque déclaration comprenant le numéro de ligne, le nom de l'objet, son type, sa taille ainsi que le type de construction de contrôle associée. Il y aura alors dans ce fichier d'indexation pour chaque objet et processus HDL, au moins le type et les coordonnées dans les fichiers de description HDL originaux ou initiaux.

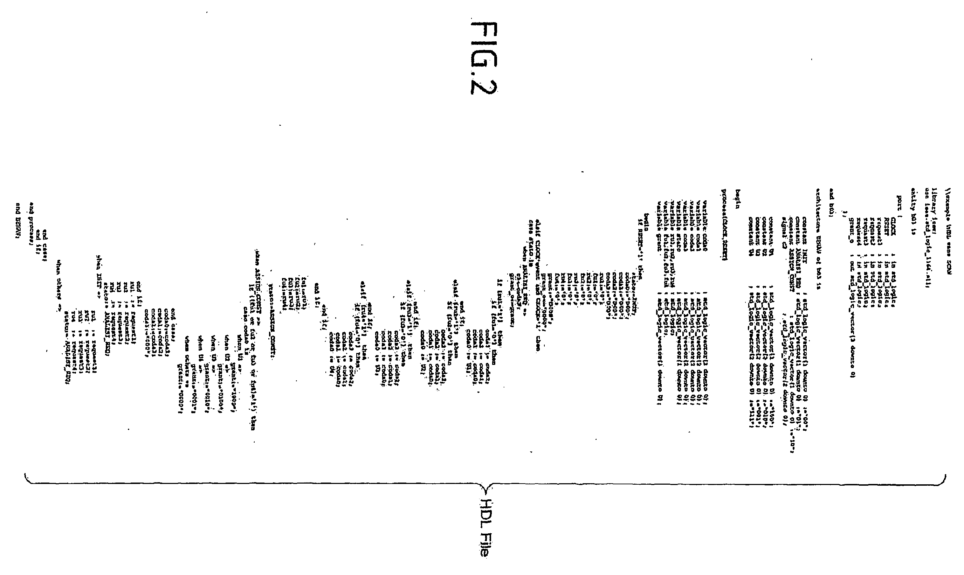

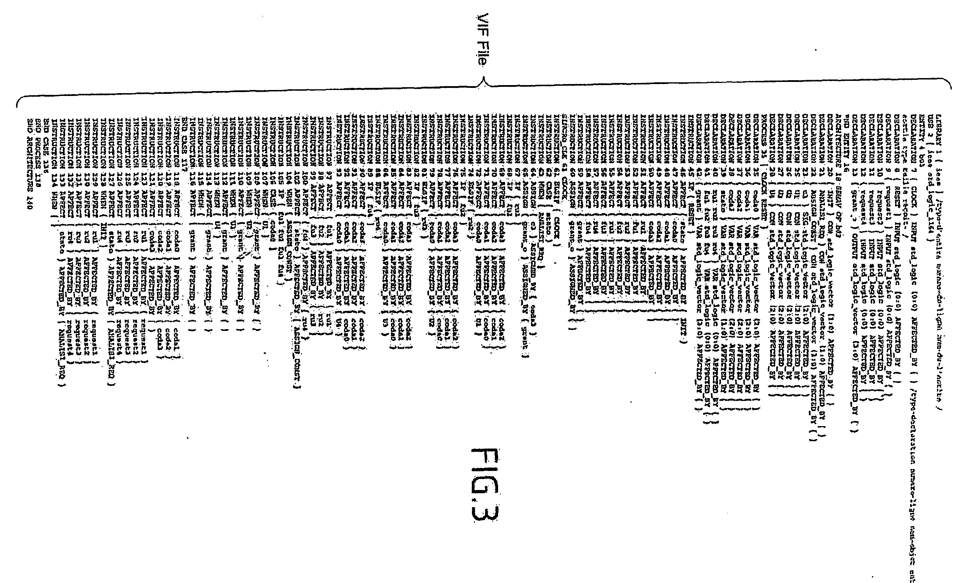

Dans le cadre de cette étape d'analyse ou d'indexation **1a** menée par exemple à partir d'un fichier, tel qu'illustré à la **fig.2****,** de description en langage VHDL d'un processus, il est généré un fichier d'indexation **VIF File** tel que représenté à la **fig. 3****.**

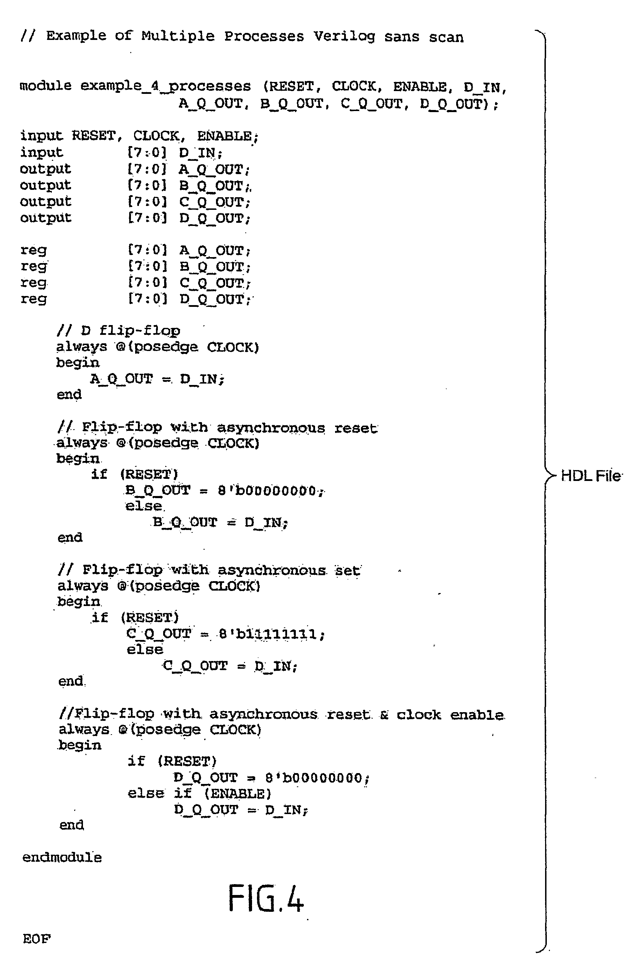

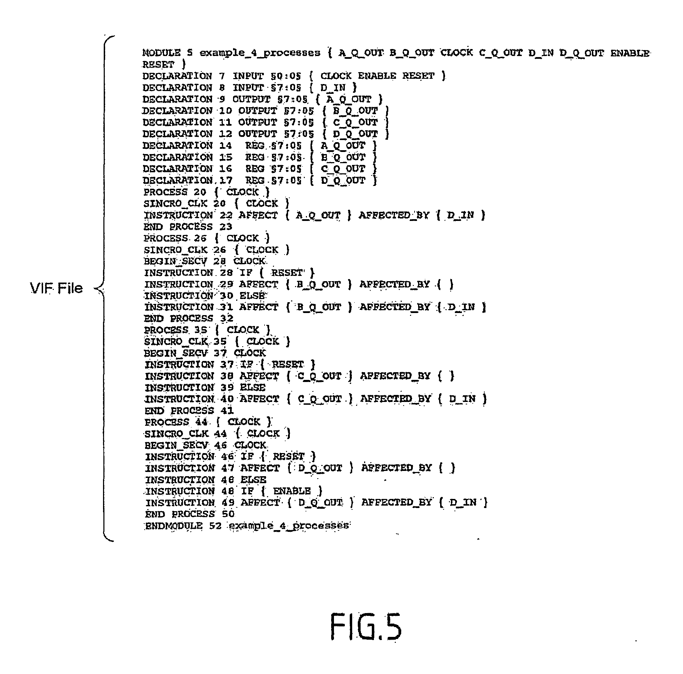

Selon l'invention cette étape d'analyse ou d'indexation **1a** peut être menée sur d'autres types de langage HDL. Ainsi la **fig. 4** illustre un exemple de fichier original ou initial de description en langage VERILOG à base de plusieurs processus et l'étape d'indexation **1a** appliquée à ce fichier permet d'obtenir un fichier d'indexation **VIF File** tel que présenté à la fig. **5****,.**

Il doit être noté qu'au sens de l'invention l'étape d'indexation **1a** peut aboutir à la création de plusieurs fichiers d'indexation, d'un système de fichier d'indexation et de manière préférée mais non strictement nécessaire à la création d'une base de donnée d'indexation.

Dans le cadre de l'étape d'indexation, le procédé selon l'invention prévoit également, en plus de l'indexation des différentes instructions élémentaires, une indexation des instances identiques susceptibles d'être présentes dans la description HDL du système. Par instances identiques il faut comprendre un même fichier ou un même ensemble de fichier HDL décrivant une partie du système qui est mise en oeuvre à plusieurs reprise dans le système.

Après cette étape d'indexation **1a,** intervient une étape **1b** de localisation automatique des instructions HDL qui seront à l'origine des éléments mémoires après synthèse du circuit. Selon l'invention cette étape de localisation **1b** est mise en oeuvre pour les différents types de langage de description HDL tels que par exemple mais non exclusivement VHDL et VERILOG qui peuvent par ailleurs être utilisés en association pour décrire un même système. Certaines parties du systèmes peuvent ainsi être décrites par des fichiers rédigés en VHDL tandis que d'autres parties du système sont décrites par des fichiers rédigés en Verilog.

Dans sa forme préférée de mise en oeuvre et pour une utilisation sur des fichiers en VHDL ou en Verilog, l'étape **1b** de localisation des instructions HDL à l'origine des éléments mémoires comprend une étape de recherche de processus synchronisés afin de détecter les objets affectés à l'intérieur de ces processus. Cette étape de recherche des processus synchronisés est effectuée à partir du résultat de l'étape d'indexation **1a** à savoir par un traitement des fichiers **VIF File** ou des données de la base de données crée ou renseignée lors de cette étape **1a** ainsi qu'éventuellement par un traitement des fichiers initiaux **HDL File** de description en langage HDL du système. Après localisation des processus synchronisés, les instructions susceptibles d'engendrer à la synthèse des éléments mémoires sont identifiées par l'application des règles suivantes :
■ tout objet affecté à l'intérieur d'un processus et qui est lu dans un autre processus ou dans la partie concurrente du code HDL sera considéré comme à l'origine un élément mémoire et
■ dans un processus synchronisé, tout objet affecté dans une branche d'une structure de contrôle « if » sans qu'il soit affecté dans toutes autres branches de cette même structure est considéré comme à l'origine d'un élément mémoire
■ dans un processus synchronisé, tout objet qui est lu avant d'être écrit est référencé comme à l'origine d'un élément mémoire.

L'étape d'identification de l'étape de localisation **1b** est menée, comme l'étape de recherche des processus synchronisés à partir du résultat de l'étape d'indexation**1a** à savoir par un traitement des fichiers **VIF File** ou des données de la base de données crée ou renseignée lors de cette étape **1a** ainsi qu'éventuellement par un traitement des fichiers initiaux **HDL File** de description en langage HDL du système. L'étape de localisation **1b** comprend également une étape d'écriture ou création d'un fichier **MEM File** qui répertorie pour chaque élément mémoire, au moins le nom de l'objet HDL correspondant, son type, sa dimension et ses coordonnées dans les fichiers de description HDL originaux. La **Fig. 6** illustre le fichier de localisation des éléments mémoire **MEM File** obtenu pour le fichier de description **HDL File** en langage VHDL, selon la **fig.2****,** par un traitement du fichier d'indexation **VIF File** de la **fig. 3****.** De la même manière **Fig. 7** montre le fichier de localisation des éléments mémoire **MEM File** obtenu pour le fichier de description **HDL File** en langage VERILOG selon la **fig.4** par un traitement du fichier d'indexation **VIF File** de la **fig. 5****.** Bien entendu, au sens de l'invention l'étape de création d'un ou d'un ensemble de fichiers de localisation tels que les fichiers **MEM File** peut tout aussi bien correspondre à la création d'une base de données ou au renseignement d'une base de donnée avec les informations sur chaque éléments mémoire telles qu'énumérées de manière non limitative ci-dessus.

L'invention se propose également de palier à d'éventuelles absences d'informations en ce qui concerne la dimension de certaines variables des fichiers originaux de description HDL en prévoyant au choix de l'utilisateur soit une étape de choix automatique de la valeur de la dimension manquante sur la base d'une valeur par défaut prédéterminée par l'utilisateur avant ou pendant la mise en oeuvre du procédé selon l'invention soit par une étape de définition interactive avec l'utilisateur du procédé au fur et à mesure de l'occurrence de ce défaut d'information. Les valeurs de dimensions ainsi définies sont alors enregistrées dans les fichiers de localisation **MEM File** ou dans la ou les bases de données correspondantes.

Après la localisation des instructions HDL qui seront à l'origine des éléments mémoire lors de la synthèse, le procédé, conformément à une caractéristique essentielle de l'invention, comprend une étape 2 d'insertion, dans une partie au moins du ou des fichiers originaux **HDL File** de description en langage HDL du système, d'instruction HDL qui lors de la synthèse du système assureront l'obtention d'au moins une chaîne de SCAN et des moyens mise en oeuvre du test de SCAN tels que par exemple mais exclusivement les entrées et sorties de SCAN, les moyens de mise en mode test du système, une horloge de test de SCAN et un contrôleur de test de SCAN.

L'insertion des instructions HDL pour le SCAN sera réalisé, afin d'éviter toute violation des règles de SCAN lors de la synthèse du circuit. Le procédé selon l'invention mettra alors en oeuvre de manière préférée une phase d'identification des éventuels domaines d'horloge différents existants accompagnée d'un enregistrement dans les fichiers ou la base de donnée ad hoc de la localisation des différents domaines d'horloge le cas échéant.

De manière préférée, l'étape **2** d'insertion des instructions HDL de SCAN est réalisée en fonction de paramètres fixés par l'utilisateur à savoir nombre et longueur des chaînes de SCAN pour l'ensemble du système ou pour certains éléments du systèmes concernés.

Ainsi l'étape d'insertion **2** mettra en oeuvre le résultat de l'étape de localisation **1** tel que **MEM File,** les fichiers originaux de description **HDL File,** la localisation des différents domaines d'horloge et les paramètres de mise de oeuvre du SCAN définis par l'utilisateur.

Selon l'invention l'insertion des instructions HDL de chaînage des éléments mémoire s'effectue, d'une part, au niveau local et, d'autre part, au niveau global.

La phase de chaînage local, répétée autant de fois que nécessaire, correspond à l'insertion d'instruction HDL de chaînage au niveau d'ensemble d'instruction HDL correspondant à un processus HDL de manière à obtenir lors de la synthèse au moins une chaîne d'éléments mémoires pour chaque processus HDL. A cet égard dans le cadre du chaînage local d'un processus décrit en langage VHDL, l'invention prévoit une phase d'insertion d'instructions VHDL de définition de signaux intermédiaires destinés à reprendre des chaînes de variables afin de permettre leur affectation et leur chaînage en dehors des processus.

Ainsi, selon une forme préférée de l'invention, la phase d'insertion automatique des instructions HDL pour le chaînage local comprend les phases suivantes :
■ insertion d'instructions HDL correspondant à des signaux de test utilisés comme port d'entrée-sortie,
■ insertion éventuelle d'instructions HDL correspondant à des signaux intermédiaires de travail,
■ insertion, au niveau de chaque processus, d'instructions HDL assurant l'obtention, lors de la synthèse du circuit, d'au moins une chaîne, dite de « SCAN», reliant les éléments mémoires propres au processus,
■ insertion d'instructions HDL assurant une affectation concurrente des chaîne des entrées et sorties des chaîne de SCAN en dehors des processus.

Il est à noter que pour respecter les règles du SCAN l'invention prévoit, lors de l'insertion des instructions HDL de chaînage, une vérification de la comptabilité des éléments mémoires entre eux et à cet effet l'étape d'insertion des instructions HDL de chaînage comprend soit une phase de transformation automatique du type et/ou de la dimension d'un ou des deux objets à l'origine du conflit, soit une phase de modification interactive avec l'utilisateur du type et/ou de la dimension d'un ou des deux objets à l'origine du conflit.

Après le chaînage local, intervient le chaînage global qui comprend une phase, répétée autant que nécessaire, d'insertion d'instruction HDL de chaînage global au niveau des fichiers de description HDL de manière à obtenir lors de la synthèse, au moins une chaîne d'éléments mémoires comprenant les chaînes d'éléments mémoire crées lors de la phase de chaînage local.

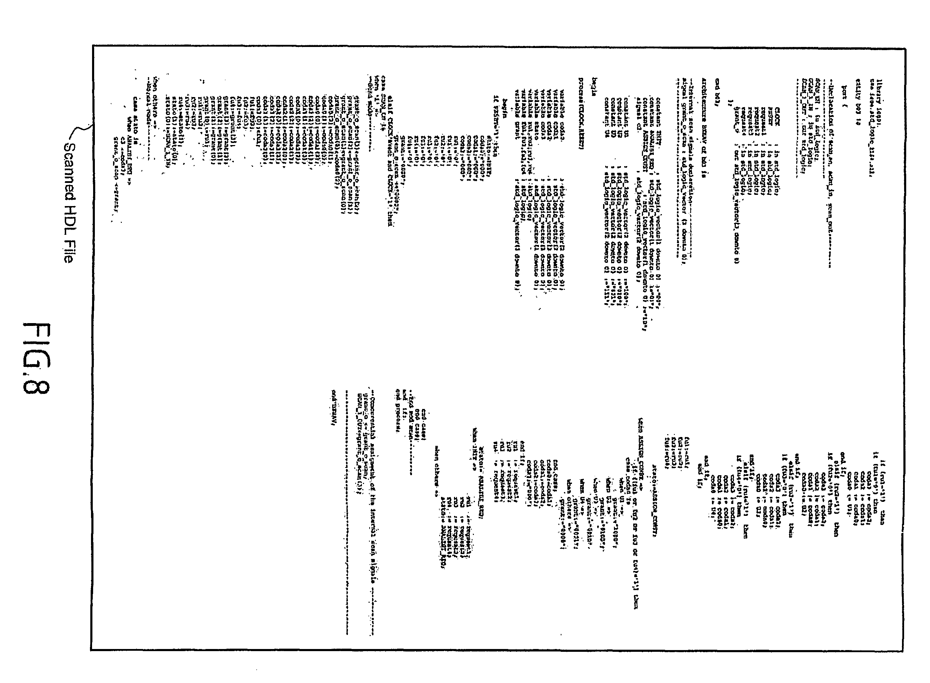

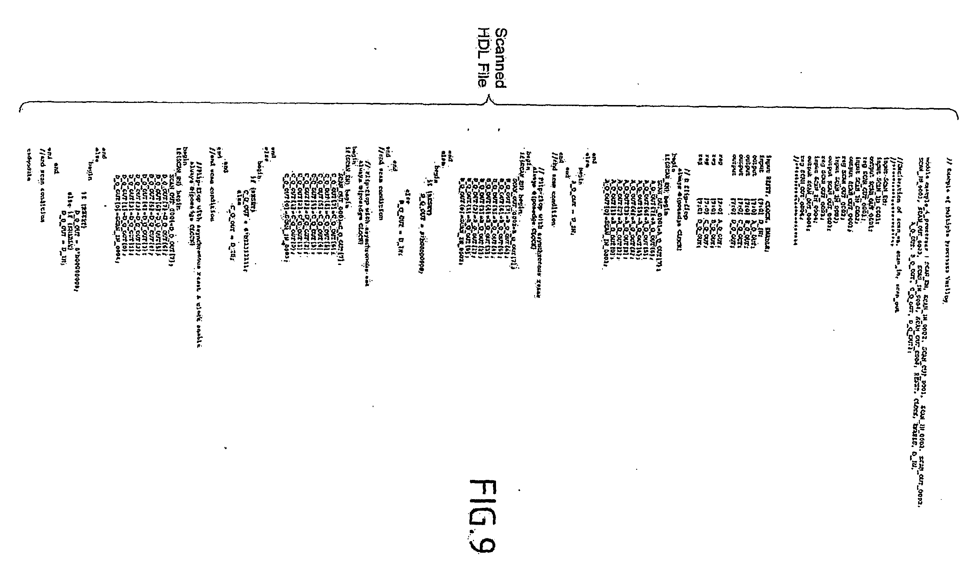

Par la mise en oeuvre du procédé selon l'invention il est ainsi obtenu, à partir du fichier original en VHDL **HDL File** illustré à la **fig. 2****,** le fichier **Scanned HDL File,** illustré **fig. 8****,** de description en VDHL du même système incorporant les instructions VHDL qui lors de la synthèse seront à l'origine des fonctionnalités de SCAN. De la même manière, la **fig. 9** montre le fichier de description en Verilog **Scanned HDL** File obtenu par la mise en oeuvre du procédé selon l'invention sur le fichier original de description en Verilog tel qu'illustré à la **fig. 4****.**

Il est à noter que le procédé selon l'invention est de préférence mis en oeuvre de manière à tenir compte, d'une part, de l'existence d'instances identiques telles qu'indexées pendant l'étape d'indexation **1a** et, d'autre part, de choix de l'utilisateur qui peuvent conduire par exemple à ce que dans une partie du système une instance est concernée par une seule chaîne de SCAN tandis que dans une autre partie du système la même instance est concernée par plusieurs chaînes de SCAN étant entendu que ces deux ou multiples instances identiques devront restées décrites par un même fichier ou ensemble de fichiers HDL. L'invention se propose alors de répondre à cet impératif en modifiant l'instance par l'insertion automatique des instructions HDL de SCAN lorsqu'elle apparaît la première fois au fils de l'insertion automatique des instructions HDL de SCAN pour l'ensemble des fichiers de description du système. Puis à chaque fois que ladite instance est rencontrée à nouveau, il est vérifié que les instructions HDL de SCAN permettent de répondre aux impératifs locaux de SCAN si cela est le cas aucune modification n'est apportée aux fichiers de description de l'instance. En revanche si cela n'est pas le cas, le ou les fichiers de description de l'instance sont modifiés et il est revenu sur tous les lieux antérieurs d'occurrence de ladite instance et il est procédé à une modification de son environnement de manière à répondre aux impératifs locaux de SCAN avec la nouvelle forme de l'instance. Cette façon de procéder permet, conformément à l'esprit de l'invention, d'éviter tout calcul d'analyse prospective sur les instances identiques et de ne revenir sur les insertions d'instruction HDL déjà effectué que si cela est nécessaire.

Dans une variante de mise en oeuvre du procédé, l'invention se propose de permettre à un concepteur de revenir sur le choix lié à la configuration des chaînes de SCAN qui sont construites au niveau RTL. A cet effet, l'invention prévoit d'insérer, en plus des instructions HDL de SCAN, des instructions HDL de reconfiguration à savoir, d'une part, des instructions HDL qui définissent des commutateurs intercalaires interposés entre chaque élément mémoire d'une chaîne de SCAN et/ou entre des parties de chaînes de SCAN et, d'autre part; des instructions HDL correspondant à au moins un contrôleur de ces commutateurs intercalaires.

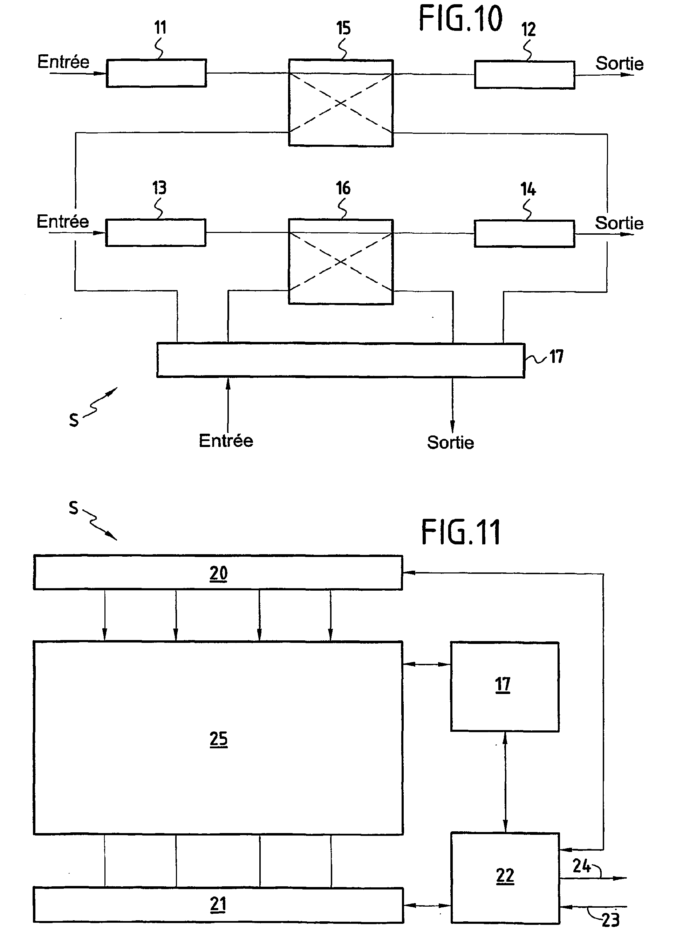

A la synthèse les instructions HDL de SCAN et de reconfiguration permettrons d'obtenir un système digital intégré **S** présentant des fonctionnalités telles que schématiquement illustrées la **fig. 10****.** Ainsi, le système **S** comprend des portions de chaîne de SCAN **11, 12, 13, 14** reliées les unes à la suite des autres, comme le montre la **fig. 10****,** par des commutateurs intercalaire **15, 16** qui sont reliés à un contrôleur **17.**

Par la mise en oeuvre de ces moyens il est possible de procéder à la reconfiguration dynamique des chaînes de SCAN après synthèse au niveau matériel en redéfinissant les paramètres suivants :
➢ taille des chaînes de SCAN
➢ configuration physique d'une ou de plusieurs chaîne de SCAN.

Comme illustré à la **fig. 10****,** une telle reconfiguration passe par le contrôleur **17** qui agit sur les commutateurs **15, 16** pour permettre l'activation des connexions des portions de chaîne **11** à **14** entre elles et avec le contrôleur **17** selon la séquence de configuration activée au niveau du contrôleur.

Dans une forme de mise en oeuvre, l'invention prévoit également une étape d'insertion automatique, dans les fichiers de description HDL du système, des instructions HDL qui après synthèse du système lui conféreront toutes les fonctionnalités d'auto test intégré de BIST pour « Buit-In Self Test ».

Ainsi l'invention prévoit une étape d'insertion automatique des instructions HDL d'auto test intégré qui lors de la synthèse seront à l'origine d'au moins :
- des moyens de génération de vecteurs de test tel qu'un générateur de vecteur de test **20,**
- des moyens d'analyse de la réponse du circuit testé tel qu'un bloc de compression de résultat de test **21,**
- des moyens de contrôle du test tel qu'un contrôleur de test **22,**
- une entrée **23** et une sortie **24** de test.

Comme le montre la **fig. 11** ces éléments sont en relation avec le circuit à tester **25** qui peut assurer l'ensemble ou une partie seulement des fonctionnalité du système **S.**

Selon l'invention le contrôleur de test sera adapté pour permettre au moins une programmation de la séquence ou des séquences d'initialisation du générateur de test afin d'augmenter la fiabilité du de l'autotest intégré et notamment la couverture de faute. Afin d'augmenter encore la couverture de faute le contrôleur de test sera adapté pour permettre une programmation de la configuration du contrôleur de test ainsi q'une programmation du contrôleur de SCAN.

Selon encore une autre caractéristique de l'invention, il est prévu, après synthèse, une étape de programmation du contrôleur de test et éventuellement du contrôleur de SCAN cette programmation peut alors être effectuée à un bas niveau sur le contrôleur de test de manière à en figer les paramètre de test.

Bien entendu diverses modifications peuvent être apportées à l'invention sans sortir de son cadre.

## Revendications

1. Procédé d'analyse d'un ensemble de fichiers originaux de description d'un système électronique digital intégré (**5**) dans un langage de description au niveau transfert de registres, dit langage HDL, en vue d'insérer de manière automatique dans les fichiers de description des instructions en langage HDL pour obtenir un nouvel ensemble de fichiers de description en langage HDL du système électronique digital intégré incorporant des fonctionnalités de test de sorte que lors de la synthèse automatique du système électronique digital intégré à partir du nouvel ensemble de fichiers le système électronique digital intégré obtenu incorpore une partie au moins des circuits électroniques logiques (**22, 23, 24**) nécessaires au test du système électronique digital intégré (**5**), procédé **caractérisé en ce qu'**il comprend :
■ une étape d'analyse ou d'indexation (**1a**) de l'ensemble de fichiers originaux de description HDL et de création d'au moins un fichier d'indexation comprenant, pour chaque objet et processus HDL, la liste des unités de conception si elles existent (entité, librairie, paquetage), pour chaque unité de conception l'ensemble des déclarations, chaque déclaration comprenant le numéro de ligne, le nom de l'objet, son type, sa taille ainsi que le type de construction de contrôle associée,
■ une étape de localisation automatique (**1**), dans les fichiers de description HDL originaux des séquences d'instructions HDL qui, lors de la synthèse du système (**3**), seront à l'origine d'éléments mémoires, qui comprend une phase de création d'un fichier de localisation des mémoires comprenant, pour chaque élément mémoire : le nom de l'objet HDL correspondant, son type, sa dimension et ses coordonnées dans les fichiers de description HDL originaux,
■ une étape d'insertion, dans une partie au moins des fichiers de description HDL, de manière séquentielle automatique et sans analyse relationnelle ou fonctionnelle des éléments mémoire identifiés, d'instructions HDL dites de SCAN assurant l'obtention, lors de la synthèse du système (**3**), d'au moins une chaîne (**11**), dite de « SCAN», reliant les éléments mémoires.

2. Procédé d'analyse et d'insertion selon la revendication 1, **caractérisé en ce qu'**il comprend une étape d'enregistrement du nouvel ensemble de fichiers de description HDL obtenus.

3. Procédé d'analyse et d'insertion selon la revendication 1 ou 2,
**caractérisé en ce que** l'étape de locatisation (**1**) des instructions HDL à l'origine des éléments mémoire comprend :
■ une étape de recherche de processus synchronisés afin de détecter les objets affectés à l'intérieur de ces processus,
■ et une mise en oeuvre des règles suivantes pour l'identification des instructions à l'origine des éléments mémoires :
• tout objet affecté à l'intérieur d'un processus et qui est lu dans un autre processus ou dans la partie concurrente du code HDL sera considéré comme un élément mémoire,
• dans un processus synchronisé, tout objet affecté dans une branche d'une structure de contrôle « if » sans qu'il soit affecté dans toutes autres branches de cette même structure est considéré comme un élément mémoire,
• dans un processus synchronisé, tout objet qui est lu avant d'être écrit est considéré comme un élément mémoire.

4. Procédé d'analyse et d'insertion selon l'une des revendications 1 à 3, **caractérisé en ce qu'**il comprend une étape d'identification des éventuels différents domaines d'horloge existants et **en ce que** l'étape d'insertion d'instructions HDL de chaînage d'éléments mémoire est réalisée de manière à créer au moins une chaîne de SCAN distincte pour chaque domaine d'horloge.

5. Procédé d'analyse et d'insertion automatique selon l'une des revendications 1 à 4, **caractérisé en ce que** l'étape d'analyse ou d'indexation comprend une étape d'indexation des instances identiques du système et **en ce que** l'étape d'insertion automatique des instructions de SCAN est réalisée pour chaque instance lorsqu'elle apparaît la première fois au fils de l'insertion automatique des instructions HDL de SCAN pour l'ensemble des fichiers de description du système puis à chaque fois que ladite instance est rencontrée à nouveau il est vérifié que les instructions HDL de SCAN permettent de répondre aux impératifs locaux de SCAN si cela est le cas aucune modification n'est apportée aux fichiers de description de l'instance en revanche si cela n'est pas le cas le ou les fichiers de description de l'instance sont modifiés et il est revenu sur tous les lieux antérieurs d'occurrence de ladite instance et il est procédé à une modification de son environnement de manière à répondre aux impératifs locaux de SCAN avec la nouvelle forme de l'instance.

6. Procédé d'analyse et d'insertion automatique selon l'une des revendications 1 à 5, **caractérisé en ce qu'**il comprend, en cas d'absence dans les fichiers de description HDL originaux d'information sur la dimension d'une variable à l'origine d'un élément mémoire, soit une étape de définition automatique de cette dimension sur la base d'une valeur par défaut prédéterminée, soit une étape de définition de cette dimension en interaction avec un utilisateur du procédé.

7. Procédé d'analyse et d'insertion automatique selon l'une des revendications 1 à 6, **caractérisé en ce qu'**il comprend :
• une étape de vérification, lors de l'insertion des instructions HDL de chaînage, de la compatibilité des éléments mémoires entre eux.
• et, en cas d'incompatibilité :
• soit une phase de transformation automatique du type et/ou de la dimension d'un ou des deux objets à l'origine du conflit,
• soit une phase de modification du type et/ou de la dimension d'un ou des deux objets à l'origine du conflit en interaction avec un utilisateur.

8. Procédé d'analyse et d'insertion automatique selon l'une des revendications 1 à 7, **caractérisé en ce que** l'étape d'insertion d'instruction HDL de chaînage d'éléments mémoires comprend :
■ une phase d'insertion d'instructions HDL de chaînage dit local d'éléments mémoires au niveau d'ensemble d'instructions HDL correspondant à un objet HDL de manière à obtenir lors de la synthèse au moins une chaîne distincte d'éléments mémoires pour chaque objet HDL,
■ une phase d'insertion d'instruction HDL de chaînage, dit global, au niveau des fichiers de description HDL, de manière à obtenir, lors de la synthèse, au moins une chaîne d'éléments mémoire comprenant les chaînes d'éléments mémoire crées lors de la phase de chaînage local.

9. Procédé d'analyse et d'insertion automatique selon la revendication 8, **caractérisé en que** l'étape d'insertion automatique des instructions HDL pour le chaînage local comprend les phases suivantes :
■ insertion d'instructions HDL correspondant à des signaux de test utilisés comme port d'entrée-sortie,
■ insertion d'instructions HDL correspondant à des signaux intermédiaires de travail dans le cas d'éléments de mémoire entre plusieurs processus impliquant des ports primaires d'entrée/sortie,
■ insertion, au niveau de chaque processus, d'instructions HDL assurant l'obtention, lors de la synthèse du circuit, d'au moins une chaîne, dite de «SCAN», reliant les éléments mémoires propres au processus,
■ insertion d'instructions HDL assurant une affectation concurrente des chaînes des entrées et sorties des chaînes de SCAN en dehors des processus.

10. Procédé d'analyse et d'insertion automatique selon l'une des revendications 1 à 9, **caractérisé en qu'**afin de permettre une reconfiguration des chaînes de SCAN après synthèse l'étape d insertion des instructions HDL de SCAN comprend :
■ une phase d'insertion d'instructions HDL qui lors de la synthèse généreront des commutateurs intercalaires entre certains au moins des éléments mémoire d'une chaîne de SCAN,
■ une phase d'insertions d'instructions HDL qui lors de la synthèse généreront un contrôleur des commutateurs intercalaires.

11. Procédé d'analyse et d'insertion automatique selon l'une des revendications 1 à 10, **caractérisé en ce que** l'étape d'insertion automatique des instructions HDL comprend une étape d'insertion d'instructions HDL d'auto test intégré qui lors de la synthèse seront à l'origine d'au moins :
- des moyens de génération de vecteurs de test tel qu'un générateur de vecteur de test (**20**),
- des moyens d'analyse de la réponse du circuit testé tel qu'un bloc de compression de résultat de test (**21**),
- des moyens de contrôle du test tel qu'un contrôleur de test (**22**),
- une entrée (**23**) et une sortie (**24**) de test.

12. Procédé d'analyse et d'insertion automatique selon la revendication 11, **caractérisé en ce que** les moyens de génération de vecteur de test comprennent un registre à décalage à contre réaction linéaire dont la séquence d'initialisation est programmable.

13. Procédé d'analyse et d'insertion automatique selon les revendications 10 et 11 ou 12, **caractérisé** les moyens de génération de vecteurs de test et d'analyse des réponses se basent sur la structure de SCAN reconfigurable.

14. Dispositif de conception automatisée en langage de description au niveau transfert de registres, dit langage HDL d'un système complet ou d'une partie de système électronique digital intégré (**5**), dispositif comprenant au moins une unité de calcul, une unité de mémoire et une unité de stockage de fichiers, **caractérisé en ce que** l'unité de stockage comprend des fichiers de description en langage HDL du système ou de la partie de système électronique intégré et **en ce que** les unités de calcul et de mémoire sont adaptées pour générer, en mettant en oeuvre le procédé selon l'une des revendications à 1 à 11 et à partir des fichiers de description HDL, de nouveaux fichiers de description HDL du système ou de la partie de système qui incorporent des instructions HDL, de manière que le système ou la partie de système électronique digital intégré obtenu à partir des nouveaux fichiers incorpore une partie au moins des circuits électroniques logiques nécessaires au test du fonctionnement des éléments mémoire.

15. Système électronique digital intégré, **caractérisé en ce qu'**il résulte de la synthèse d'un ensemble de fichier de description en langage HDL obtenu par la mise en oeuvre du procédé selon l'une des revendications 1 à 11 et comprend une partie au moins des circuits électroniques logiques nécessaires au test du fonctionnement des éléments mémoire, tels qu'une ou plusieurs chaînes de SCAN et **caractérisé en ce qu'**il est adapté pour permettre une reconfiguration des chaînes de SCAN et **en ce qu'**il comprend au moins :
■ des commutateurs intercalaires (**15, 16**) placés entre certains au moins des éléments mémoire (**11, 12**) d'une chaîne de SCAN,
■ et un contrôleur des commutateurs intercalaires.

16. Système électronique digital intégré selon la revendication 15,
**caractérisé en ce qu'**il comprend :
- des moyens de génération de vecteurs de test tel qu'un générateur de vecteur de test (**20**),
- des moyens d'analyse de la réponse du circuit testé tel qu'un bloc de compression de résultat de test (**21**),
- des moyens de contrôle du test tel qu'un contrôleur de test (**22**),
- une entrée (**23**) et une sortie (**24**) de test.

17. Système électronique digital intégré selon la revendication 16,
**caractérisé en ce que** les moyens de génération de vecteur de test comprennent un registre à décalage à contre réaction linéaire dont la séquence d'initialisation est programmable.

18. Système électronique digital intégré selon les revendications 15 et 16 ou 17, **caractérisé en ce que** les moyens de génération de vecteurs de test et d'analyse des réponses se basent sur la structure de SCAN reconfigurable.

## Claims

1. Method for analysing a set of original description files for an integrated digital electronic system (5) in a description language called the HDL language, at the register transfer level, in order to automatically insert instructions in the HDL language into description files to obtain a new set of description files in the HDL language for the integrated digital electronic system including test functions such that during automatic synthesis of the integrated digital electronic system using a new set of files, the integrated digital electronic system obtained builds in at least some of the logical electronic circuits (22, 23, 24) necessary to test the integrated digital electronic system (5),
method **characterised in that** it includes the following steps:
• a step (1a) for analysis or indexing of all original HDL description files and creation of at least one indexing file containing the list of design units if they exist (entity, library, packet), for each object and HDL process, and all declarations for each design unit, each declaration including the line number, the object name, type, size and the associated control construction type;
• automatic localisation (1) of HDL instruction sequences that will be at the origin of the memory elements during synthesis of the system (3), in the original HDL description files; which includes a phase to create a memory localisation file comprising, for each memory element, the name of the corresponding HDL object, its type, dimension and coordinates in the original HDL description files;
• automatic and sequential insertion in at least part of HDL description files, and without relational or functional analysis of the identified memory elements, of so-called SCAN HDL instructions used to obtain at least one so-called "SCAN" chain (11) connecting the memory elements, during synthesis of the system (3).

2. Analysis and insertion method according to claim 1, **characterised in that** it includes a step to record the new set of HDL description files obtained.

3. Analysis and insertion method according to claim 1 or 2, **characterised in that** the step (1) for localising HDL instructions at the origin of the memory elements includes:
• a step to search for synchronised processes to detect objects assigned within these processes,
• and application of the following rules for identification of instructions at the origin of memory elements:
• any object assigned within one process and that is read in another process or in the concurrent part of the HDL code will be considered as being a memory element,
• in a synchronised process, any object assigned within one branch of an "if" control structure without being assigned within all other branches of this same structure is considered to be a memory element,
• in a synchronised process, any object that is read before it is written is considered to be a memory element.

4. Analysis and insertion method, according to any one of claims 1 to 3, **characterised in that** it includes a step to identify any different existing clock domains, and **in that** the step to insert HDL memory element chaining instructions is carried out so as to create at least one distinct SCAN chain for each clock domain.

5. Analysis and automatic insertion method according to claim one of claims 1 to 4, **characterised in that** the analysis or indexing step includes an indexing step of identical instances of the system and **in that** the step for automatically inserting the SCAN instructions is performed for each instance when it appears for the first time during automatic insertion of SCAN HDL instructions for all description files in the system, then, whenever the said instance is encountered again, a check is made that the SCAN HDL instructions can be used to satisfy local SCAN constraints, and if this is the case, no modification is made to description files of the instance. On the other hand if this is not the case, the description file(s) of the instance is (are) modified and all previous locations in which the said instance occurred are verified and its environment is modified so as to satisfy local SCAN constraints with the new form of the instance.

6. Analysis and automatic insertion method according to one of claims 1 to 5, **characterised in that,** in the case of a lack of information related to the dimension of a variable at the origin of a memory element in the original HDL description files, it includes either a step to automatically define this value based on a predetermined default value, or a step in which a user of the method makes the definition interactively.

7. Analysis and automatic insertion method according to one of claims 1 to 6, **characterised in that** it includes:
• a step to verify the compatibility of memory elements with each other, when inserting the HDL chaining instructions,
• and in case of incompatibility:
• either a phase for automatic transformation of the type and / or dimension of one of the two objects at the origin of the conflict,
• or a phase in which the user interactively modifies the type and / or the dimension of one of the two objects at the origin of the conflict.

8. Analysis and automatic insertion method according to one of claims 1 to 7, **characterised in that** the HDL instruction insertion step for chaining of memory elements includes:
• a phase to insert HDL chaining instructions of memory elements, called local chaining, in the set of HDL instructions corresponding to an HDL object so as to obtain at least one distinct chain of memory elements for each HDL object during the synthesis,
• a phase to insert HDL chaining instructions, called global chaining, in the HDL description files, so as to obtain at least one chain of memory elements during the synthesis, comprising the chains of memory elements created during the local chaining phase.

9. Analysis and automatic insertion method according to claim 8, **characterised in that** the step for automatic insertion of the HDL instructions for local chaining includes the following phases:
• insertion of HDL instructions corresponding to test signals used as an inputoutput port,
• insertion of HDL instructions corresponding to intermediate work signals, in the case of memory elements between several processes involving primary input/output ports,
• insertion of HDL instructions in each process, so as to obtain at least one so-called "SCAN" chain during synthesis of the circuit, connecting memory elements specific to the process,
• insertion of HDL instructions providing concurrent assignment of input and output chains of SCAN chains external to processes.

10. Analysis and automatic insertion method according to one of claims 1 to 9, **characterised in that** in order to enable reconfiguration of SCAN chains after synthesis, the step to insert HDL SCAN instructions includes:
• a phase to insert HDL instructions that will generate intermediate switches inserted between some at least of the memory elements of a SCAN chain, during synthesis,
• a phase to insert HDL instructions that will generate a controller of these intermediate switches, during synthesis.

11. Analysis and automatic insertion method according to one of claims 1 to 10, **characterised in that** the step for automatic insertion of HDL instructions includes a step for insertion of built-in self-test HDL instructions which will be at the origin of at least the following during the synthesis:
- test pattern generation means such as a test pattern generator (20),
- means of analysing the response of the tested circuit such as a test result compression block (21),
- test control means such as a test controller (22),
- a test input (23) and output (24).

12. Analysis and automatic insertion method according to claim 11, **characterised in that** the means for generating test patterns include a linear Parallel Random Pattern Generator (PRPG) for which the initialisation sequence is programmable.

13. Analysis and automatic insertion method according to claims 10 and 11 or 12, **characterised in that** means for generating test patterns and analysing responses are based on the reconfigurable SCAN structure.

14. Device for automated design of a complete system or part of an integrated digital electronic system (5) in a description language at the register transfer level, called the HDL language, this device including at least one calculation unit, a memory unit, and a file storage unit, **characterised in that** the storage unit includes HDL language description files of the system or part of the integrated electronic system and **in that** the calculation and memory units are adapted to generate new HDL description files of the system or part of this system that include HDL descriptions, using the method according to one of claims 1 to 11, and starting from HDL description files, such that the system or part of the integrated digital electronic system obtained from the new files includes at least part of the electronic logic circuits necessary for the operational test of the memory elements.

15. Integrated digital electronic system, **characterised in that** it results from the synthesis of a set of description files in the HDL language obtained by use of the method according to one of claims 1 to 11 and **in that** it includes at least part of the logical electronic circuits necessary to test operation of the memory elements, such as one or several SCAN chains and **characterised in that** it includes at least:
• intermediate switches (15, 16) placed between at least some of the memory elements (11, 12) in a SCAN chain;
• and an intermediate switch controller.

16. Integrated digital electronic system according to claim 14 or 15, **characterised in that** it includes:
- test pattern generation means such as a test pattern generator (20),
- means of analysing the response of the tested circuit such as a test result compression block (21),
- test control means such as a test controller (22),
- a test input (23) and output (24).

17. Integrated digital electronic system according to claim 16, **characterised in that** the means for generating test patterns include a linear Parallel Random Pattern Generator (PRPG) for which the initialisation sequence is programmable.

18. Integrated digital electronic system according to claims 15 and 16 or 17, **characterised in that** the means for generating test patterns and analysing responses are based on the reconfigurable SCAN structure.

## Patentansprüche

1. Verfahren zur Analyse eines Satzes von Originalbeschreibungsdateien eines integrierten digitalen elektronischen Systems (5) in einer Beschreibungssprache auf Register-Transfer-Ebene, der sogenannten HDL-Sprache, um in die Beschreibungsdateien Anweisungen in HDL-Sprache automatisch einzufügen, um einen neuen Satz von Beschreibungsdateien in HDL-Sprache des Testfunktionalitäten beinhaltenden integrierten digitalen elektronischen Systems zu erhalten, so daß während der automatischen Synthese des integrierten digitalen elektronischen Systems anhand des neuen Satzes von Dateien das erhaltene integrierte digitale elektronische System wenigstens einen Teil der logischen elektronischen Schaltkreise (22, 23, 24) aufnimmt, die für den Test des integrierten digitalen elektronischen Systems (5) erforderlich sind,
Verfahren, das **dadurch gekennzeichnet ist, daß** es folgendes umfaßt:
- einen Schritt zur Analyse oder Indizierung (1a) des Satzes von originalen HDL-Beschreibungsdateien sowie zur Erzeugung wenigstens einer Indizierungsdatei, die für jedes HDL-Objekt und jeden HDL-Prozeß die Liste der Designeinheiten sofern vorhanden (Entity, Library, Package), für jede Designeinheit die Gesamtheit der Deklarationen umfaßt, wobei jede Deklaration die Zeilennummer, den Namen des Objekts, seinen Typ, seine Größe sowie den Typ des zugeordneten Kontrollkonstruktes umfaßt,
- einen Schritt zur automatischen Lokalisierung (1) - in den originalen HDL-Beschreibungsdateien - der HDL-Anweisungssequenzen, die während der Synthese des Systems (3) Speicherelemente erzeugen werden; er umfaßt eine Phase zum Generieren einer Datei zur Lokalisierung der Speicher, die für jedes Speicherelement folgendes umfaßt, nämlich den Namen des entsprechenden HDL-Objekts, seinen Typ, seine Dimension sowie seine Koordinaten in den originalen HDL-Beschreibungsdateien,
- einen Schritt zum Einfügen - in wenigstens einen Teil der HDL-Beschreibungsdateien - auf sequentielle automatische Weise und ohne relationale oder funktionale Analyse der identifizierten Speicherelemente, von sogenannten SCAN-HDL-Anweisungen, die den Erhalt wenigstens einer die Speicherelemente verbindenden, sogenannten "SCAN"-Kette (11) während der Synthese des Systems (3) sicherstellen.

2. Analyse- und Einfügungsverfahren nach Anspruch 1, **dadurch gekennzeichnet, daß** es einen Schritt zum Speichern des neuen Satzes von erhaltenen HDL-Beschreibungsdateien umfaßt.

3. Analyse- und Einfügungsverfahren nach Anspruch 1 oder 2, **dadurch gekennzeichnet, daß** der Schritt der Lokalisierung (1) der den Speicherelementen zugrunde liegenden HDL-Anweisungen folgendes umfaßt:
- einen Schritt zur Suche synchronisierter Prozesse, um die innerhalb dieser Prozesse zugeordneten Objekte ausfindig zu machen, und
- eine Ausführung der folgenden Regeln für die Identifizierung der den Speicherelementen zugrunde liegenden Anweisungen:
- jedes innerhalb eines Prozesses zugeordnete Objekt, das in einem anderen Prozeß oder im konkurrierenden Teil des HDL-Codes gelesen wird, wird als ein Speicherelement betrachtet,
- in einem synchronisierten Prozeß wird jedes in einem Zweig einer "If"-Kontrollstruktur zugeordnete Objekt, ohne daß es in allen anderen Zweigen dieser gleichen Struktur zugeordnet ist, als ein Speicherelement betrachtet,
- in einem synchronisierten Prozeß wird jedes Objekt, das gelesen wird, bevor es geschrieben wird, als ein Speicherelement betrachtet.

4. Analyse- und Einfügungsverfahren nach einem der Ansprüche 1 bis 3, **dadurch gekennzeichnet, daß** es einen Schritt zur Identifizierung der möglichen vorhandenen unterschiedlichen Taktdomänen umfaßt, und daß der Schritt des Einfügens von HDL-Anweisungen zur Verkettung von Speicherelementen derart vollzogen wird, daß für jede Taktdomäne wenigstens eine andere SCAN-Kette erzeugt wird.

5. Verfahren zur Analyse und zum automatischen Einfügen nach einem der Ansprüche 1 bis 4, **dadurch gekennzeichnet, daß** der Analyse- oder Indizierungsschritt einen Schritt zur Indizierung der identischen Instanzen des Systems umfaßt, und daß der Schritt des automatischen Einfügens der SCAN-Anweisungen für jede Instanz durchgeführt wird, wenn sie zum ersten Mal beim automatischen Einfügen der SCAN-HDL-Anweisungen für alle Beschreibungsdateien des Systems auftritt, anschließend wird jedes Mal, wenn die genannte Instanz erneut auftritt, überprüft, ob die SCAN-HDL-Anweisungen ermöglichen, den lokalen SCAN-Anforderungen gerecht zu werden; ist dies der Fall, wird an den Beschreibungsdateien der Instanz keinerlei Änderung vorgenommen, ist dies hingegen nicht der Fall, wird bzw. werden die Beschreibungsdateien der Instanz modifiziert und man kehrt zu allen früheren Orten eines Auftretens der Instanz zurück und vollzieht eine Änderung ihrer Umgebung, um mit der neuen Form der Instanz den lokalen SCAN-Anforderungen gerecht zu werden.

6. Verfahren zur Analyse und zum automatischen Einfügen nach einem der Ansprüche 1 bis 5, **dadurch gekennzeichnet, daß** es - falls in den originalen HDL-Beschreibungsdateien keine Information über die Dimension einer einem Speicherelement zugrunde liegenden Variablen vorhanden ist - entweder einen Schritt zum automatischen Definieren dieser Dimension auf der Grundlage eines vorbestimmten Default-Wertes oder einen Schritt zum Definieren dieser Dimension in Wechselwirkung mit einem Benutzer des Verfahrens umfaßt.

7. Verfahren zur Analyse und zum automatischen Einfügen nach einem der Ansprüche 1 bis 6, **dadurch gekennzeichnet, daß** es folgendes umfaßt:
- einen Schritt zum Verifizieren der Kompatibilität der Speicherelemente untereinander während des Einfügens der Verkettungs-HDL-Anweisungen, und
- im Fall einer Inkompatibilität:
- entweder eine Phase zur automatischen Transformation des Typs und/oder der Dimension eines oder der beiden konfliktursächlichen Objekte,
- oder eine Phase zur Modifikation des Typs und/oder der Dimension eines oder der beiden konfliktursächlichen Objekte in Wechselwirkung mit einem Benutzer.

8. Verfahren zur Analyse und zum automatischen Einfügen nach einem der Ansprüche 1 bis 7, **dadurch gekennzeichnet, daß** der Schritt des Einfügens von HDL-Anweisungen zur Verkettung von Speicherelementen folgendes umfaßt:
- eine Phase zum Einfügen von HDL-Anweisungen zur sogenannten lokalen Verkettung von Speicherelementen auf der Ebene einer einem HDL-Objekt entsprechenden HDL-Anweisungseinheit, um während der Synthese für jedes HDL-Objekt wenigstens eine andere Kette von Speicherelementen zu erhalten,
- eine Phase zum Einfügen von HDL-Anweisungen zur sogenannten globalen Verkettung auf der Ebene der HDL-Beschreibungsdateien, um während der Synthese wenigstens eine Kette von Speicherelementen zu erhalten, welche die während der Phase der lokalen Verkettung erzeugten Speicherelement-Ketten umfaßt.

9. Verfahren zur Analyse und zum automatischen Einfügen nach Anspruch 8, **dadurch gekennzeichnet, daß** der Schritt des automatischen Einfügens der HDL-Anweisungen für die lokale Verkettung die folgenden Phasen umfaßt:
- Einfügen von HDL-Anweisungen, die Testsignalen entsprechen, welche als Eingabe-Ausgabe-Port verwendet werden,
- Einfügen von Arbeitszwischensignalen entsprechenden HDL-Anweisungen im Falle von Speicherelementen zwischen mehreren Prozessen, die primäre Eingabe-Ausgabe-Ports enthalten,
- Einfügen - auf der Ebene eines jeden Prozesses - von HDL-Anweisungen, die den Erhalt wenigstens einer sogenannten "SCAN"-Kette, welche die dem Prozeß eigenen Speicherelemente verbindet, während der Synthese der Schaltung sicherstellen,
- Einfügen von HDL-Anweisungen, die eine konkurrierende Zuweisung der Ketten der Ein- und Ausgänge der SCAN-Ketten außerhalb der Prozesse sicherstellen.

10. Verfahren zur Analyse und zum automatischen Einfügen nach einem der Ansprüche 1 bis 9, **dadurch gekennzeichnet, daß** - zur Ermöglichung einer Rekonfiguration der SCAN-Ketten nach der Synthese - der Schritt des Einfügens der SCAN-HDL-Anweisungen folgendes umfaßt:
- eine Phase zum Einfügen von HDL-Anweisungen, die während der Synthese zwischen wenigstens einigen der Speicherelemente einer SCAN-Kette Zwischenschalter generieren werden,
- eine Phase zum Einfügen von HDL-Anweisungen, die während der Synthese einen Controller der Zwischenschalter generieren werden.

11. Verfahren zur Analyse und zum automatischen Einfügen nach einem der Ansprüche 1 bis 10, **dadurch gekennzeichnet, daß** der Schritt des automatischen Einfügens der HDL-Anweisungen einen Schritt zum Einfügen von HDL-Anweisungen eines integrierten Auto-Tests umfaßt, die während der Synthese wenigstens folgendem zugrunde liegen werden:
- den Mitteln zum Generieren von Testvektoren, wie einem Testvektor-Generator (20),
- den Mitteln zum Analysieren der Antwort der getesteten Schaltung, wie einem Block zum Komprimieren des Testergebnisses (21),
- den Testkontrollmitteln, wie einem Testcontroller (22),
- einem Test-Eingang (23) und einem Test-Ausgang (24).

12. Verfahren zur Analyse und zum automatischen Einfügen nach Anspruch 11, **dadurch gekennzeichnet, daß** die Mittel zur Testvektorgenerierung ein Schieberegister mit linearer Gegenreaktion umfassen, dessen Initialisierungssequenz programmierbar ist.

13. Verfahren zur Analyse und zum automatischen Einfügen nach den Ansprüchen 10 und 11 oder 12, **dadurch gekennzeichnet, daß** die Mittel zur Generierung von Testvektoren und zum Analysieren der Antworten auf der rekonfigurierbaren SCAN-Struktur basieren.

14. Vorrichtung zum automatisierten Entwurf in einer Beschreibungssprache auf Register-Transfer-Ebene, der sogenannten HDL-Sprache, eines vollständigen integrierten digitalen elektronischen Systems (5) oder eines Teils dessen, wobei die Vorrichtung wenigstens eine Recheneinheit, eine Speicher-Einheit und eine Einheit zur Speicherung von Dateien umfaßt, **dadurch gekennzeichnet, daß** die Speicherungseinheit Beschreibungsdateien in HDL-Sprache des integrierten elektronischen Systems oder des Teils dessen enthält, und daß die Recheneinheit und die Speicher-Einheit geeignet sind, unter Durchführung des Verfahrens nach einem der Ansprüche 1 bis 11 sowie mittels der HDL-Beschreibungsdateien neue HDL-Beschreibungsdateien des Systems oder des Systemteils zu generieren, die HDL-Anweisungen beinhalten, so daß das mittels der neuen Dateien erhaltene integrierte digitale elektronische System oder der Teil dessen wenigstens einen Teil der für den Funktionstest der Speicherelemente erforderlichen logischen elektronischen Schaltkreise beinhaltet.

15. Integriertes digitales elektronisches System, **dadurch gekennzeichnet, daß** es aus der Synthese eines Satzes von Beschreibungsdateien in HDL-Sprache resultiert, erhalten durch Durchführung des Verfahrens nach einem der Ansprüche 1 bis 11, und wenigstens einen Teil der für den Funktionstest der Speicherelemente erforderlichen logischen elektronischen Schaltkreise, wie eine oder mehrere SCAN-Ketten umfaßt, und **dadurch gekennzeichnet, daß** es geeignet ist, eine Rekonfiguration der SCAN-Ketten zu ermöglichen, und daß es wenigstens folgendes aufweist:
- Zwischenschalter (15, 16), die zwischen wenigstens einigen der Speicherelemente (11, 12) einer SCAN-Kette plaziert sind, und
- einen Controller der Zwischenschalter.

16. Integriertes digitales elektronisches System nach Anspruch 15, **dadurch gekennzeichnet, daß** es folgendes umfaßt:
- Mittel zum Generieren von Testvektoren, wie einen Testvektor-Generator (20),
- Mittel zum Analysieren der Antwort der getesteten Schaltung, wie einen Block zum Komprimieren des Testergebnisses (21),
- Testkontrollmittel, wie einen Testcontroller (22),
- einen Test-Eingang (23) und einen Test-Ausgang (24).

17. Integriertes digitales elektronisches System nach Anspruch 16, **dadurch gekennzeichnet, daß** die Mittel zur Testvektorgenerierung ein Schieberegister mit linearer Gegenreaktion umfassen, dessen Initialisierungssequenz programmierbar ist.

18. Integriertes digitales elektronisches System nach den Ansprüchen 15 und 16 oder 17, **dadurch gekennzeichnet, daß** die Mittel zur Generierung von Testvektoren und zum Analysieren der Antworten auf der rekonfigurierbaren SCAN-Struktur basieren.
